# EUROPÄISCHE PATENTSCHRIFT

(11) **EP 0 607 203 B1**
(45) Veröffentlichungstag und Bekanntmachung des Hinweises auf die Patenterteilung: **12.06.1996**
(21) Anmeldenummer: 92920548.2
(22) Anmeldetag: 01.10.1992
(51) Int. Cl.: G06F 1/18

(54) **SMARTDISKETTE-SCHREIB-/LESEEINRICHTUNG**
SMART-DISKETTE READ-WRITE DEVICE
DISPOSITIF DE LECTURE ET D'ECRITURE POUR DISQUETTE INTELLIGENTE

(30) Priorität: 08.10.1991 DE 4133246
(43) Veröffentlichungstag der Anmeldung: 27.07.1994
(73) Patentinhaber: SMART-DISKETTE GMBH, W-6270 Idstein (DE)
(72) Erfinder: EISELE, Raymund, H., D-6270 Idstein (DE); BARRETT, Paul, Worcester Park, Surrey KT4 7PU (GB)
(74) Vertreter: Leineweber, Jürgen, Dipl.-Phys.
(86) Internationale Anmeldenummer: EP9202272
(87) Internationale Veröffentlichungsnummer: WO9307555

(56) Entgegenhaltungen:
- EP-A- 0 373 411
- EP-A- 0 437 129
- WO-A-90/04847
- C'T Zeitschrift, Heft 4, 1991, Seite 308-312
- Computer Enzyklopädie Hans Herbert Schulze, Bd 2: C64-Dynamo, Seite 653-654

## Beschreibung

Die Erfindung bezieht sich auf ein System, bestehend aus einem in EDV-Einrichtungen einbaubaren Gerät und einer Smartdiskette mit den Merkmalen des Oberbegriffs des Patentanspruchs 1. Aus der DE-A-39 03 454 ist eine in EDV-Einrichtungen einsteckbare Smartdiskette bekannt, die mit einer besonderen Schnittstelle in Form eines induktiven Wandlers ausgerüstet ist. Dieser Wandler ist derart ausgebildet, daß eine Datenübertragung zwischen einem in der Diskette befindlichen Prozessor und der EDV-Einrichtung über die in der EDV-Einrichtung ohnehin vorhandenen Schreib-/ Leseeinrichtung durchführbar ist. Der besondere, mit diesen Merkmalen verbundene Vorteil besteht darin, daß ein Datenaustausch zwischen dem Prozessor der Diskette und der EDV-Einrichtung möglich ist, ohne daß zusätzliche Schnittstellen erforderlich sind. Die Ausbildung des Wandlers ist aus der DE-A 40 36 336 bekannt.

Aus der WO-Schrift 90/048 47 (Gordon) ist ein Kupplungsstück (coupler 6) bekannt, welches die äußere Form einer Diskette hat. Über das Kupplungsstück können externe EDV-Einrichtungen mit einem Computer verbunden werden, der mit einer Diskettenstation ausgerüstet ist. Sowohl die DE-A-39 03 454 als auch die WO 90/04847 beschreiben die Verwendung von standardmäßig ausgebildeten Diskettenstationen, also mit beweglichem Schreib-Lese-kopf und Antriebsmotor für eine Magnetscheibe, da nach beiden Druckschriften vom besonderen Vorteil Gebrauch gemacht wird, daß in die jeweilige Diskettenstation sowohl Standard-Disketten als auch die "Smart-Diskette" (DE-A-39 03 454) bzw. das kupplungsstück (WO 90/048 47) einsteckbar sind.

Aus der US-A-3,864,743 ist ein Adapter in der äußeren Form einer Magnetband-Kassette bekannt, bei dem das Abspielgerät mit einem feststehenden Lesekopf versehen ist und Steckkontakte für die Stromversorgung des Adapters vorgesehen sind.

Aus der US-A-3,978,524 ist eine Einrichtung in der äußeren Form einer Magnetband-kassette bekannt, die mit einer Schnittstelle in der Form einer Spule versehen ist. Die Analog-Signale werden dabei von einem Mikrofon, Musikinstrument oder einer herkömmtlichen Magnetband-Kassette empfangen, an die Schnittstelle weitergeleitet und über die Schnittstelle an den Lesekopf eines Kassettanrekorders übertragen.

Der vorliegenden Erfindung liegt die Aufgabe zugrunde, die in den meisten EDV-Einrichtungen vorhandene Diskettenstation, die über einen Antriebsmotor und bewegliche Schreib-/ Leseköpfe verfügt, derart umzugestalten, daß für bestimmte Anwendungsfälle ein verbesserter Gebrauchswert erzielt wird.

Diese Aufgabe wird durch die kennzeichnenden Merkmale des Patentanspruchs 1 gelöst.

In die Smartdisketten-Schreib-/Leseeinrichtung kann eine Smartdiskette eingeschoben und arretiert werden. Der Datenaustausch mit dem in der Smartdiskette befindlichen Wandler und Prozessor mit Speicher erfolgt über einen einzigen fest installierten Schreib-/Lesekopf der Smartdisketten-Schreib-/ Leseeinrichtung. Der Schreib-/Lesekopf ist mit einem Kontroller verbunden, der das Protokoll zum Schreiben und Lesen Abhandelt und seinerseits mit dem Prozessor der EDV-Einrichtung verbunden ist. Wahlweise kann die Smartdisketten-Schreib-/ Leseeinrichtung auch einen Stecker enthalten, über den eine entsprechend ausgestattete Smartdiskette mit Strom versorgt wird. Dieser Stecker kann auch dafür verwendet werden, um eine in einer entsprechend ausgestatteten Smartdiskette befindliche Batterie aufzuladen.

Bei den zur Zeit bereits vorhandenen extrem flachen und leichten EDV-Einrichtungen mit den Funktionen eines Personal Computers, allgemein als Notebook oder Notpad bezeichnet, wird, um Energie zu sparen, weitestgehend auf den Einsatz beweglicher Teile verzichtet. Dies kann durch den Einsatz der Smartdisketten-Schreib-/Leseeinrichtung erreicht werden. Zum Datenaustausch mit anderen EDV-Einrichtungen, die über eine standardmäßig vorhandene 3 1/2 Zoll Diskettenstation verfügen, kann die Smartdiskette ebenfalls verwendet werden.

Üblicherweise wird bei Notebooks/Notepads als Speichermedium eine sogenannte Speicherkarte in der Form einer ISO-Karte, aber mit einer Dicke von ca. 3 mm eingesetzt. Um Daten mit einer anderen EDV-Einrichtung auszutauschen, muß bei dieser ein entsprechendes Schreib-/Lesegerät installiert werden, in das die Speicherkarte gesteckt werden kann. Ein weiterer Nachteil beim Einsatz von Speicherkarten liegt darin, daß die Benutzer zwar an den Umgang mit Disketten gewohnt sind, der Umgang mit Speicherkarten ist jedoch noch nicht üblich.

Aus Datensicherheitsgründen werden öfters EDV-Einrichtungen, die an einem Netzwerk angebunden sind, ohne ein Disketten-Laufwerk installiert. Um jedoch den zugriff auf die EDV-Einrichtung und das Netzwerk zu schützen, werden z.B. Chipkarten mit entsprechenden (teuren) Schreib-/Leseein-richtungen benutzt.

Mit der vorliegenden Erfindung werden die genannten Nachteile gänzlich beseitigt. Die Smartdisketten-Schreib-/ Leseeinrichtung wird bei Notebooks/Notepads eingesetzt. Auch bei anderen EDV-Einrichtungen ohne ein übliches Disketten-Laufwerk kann die Smartdisketten-Schreib-/Leseeinrichtung eingesetzt werden. Die Smartdisketten-Schreib-/Leseein-richtung kann nicht mit herkömmlichen Disketten benutzt werden, somit entfallen auch die damit verbundenen Sicherheitsprobleme. Der Zugriffsschutz zur EDV-Einrichtung und zum Netzwerk erfolgt über die Smartdisketten-Schreib-/ Leseeinrichtung mit Hilfe der Smartdiskette, die die entsprechenden Berechtigungen enthält und auch bei anderen handelsüblichen 3 1/2 Zoll-Laufwerken eingesetzt werden kann.

Weitere Vorteile und Anwendungsmöglichkeiten dieser Erfindung sollen anhand von in den Figuren schematisch dargestellten Ausführungsbeispielen erläutert werden.

Es zeigend :

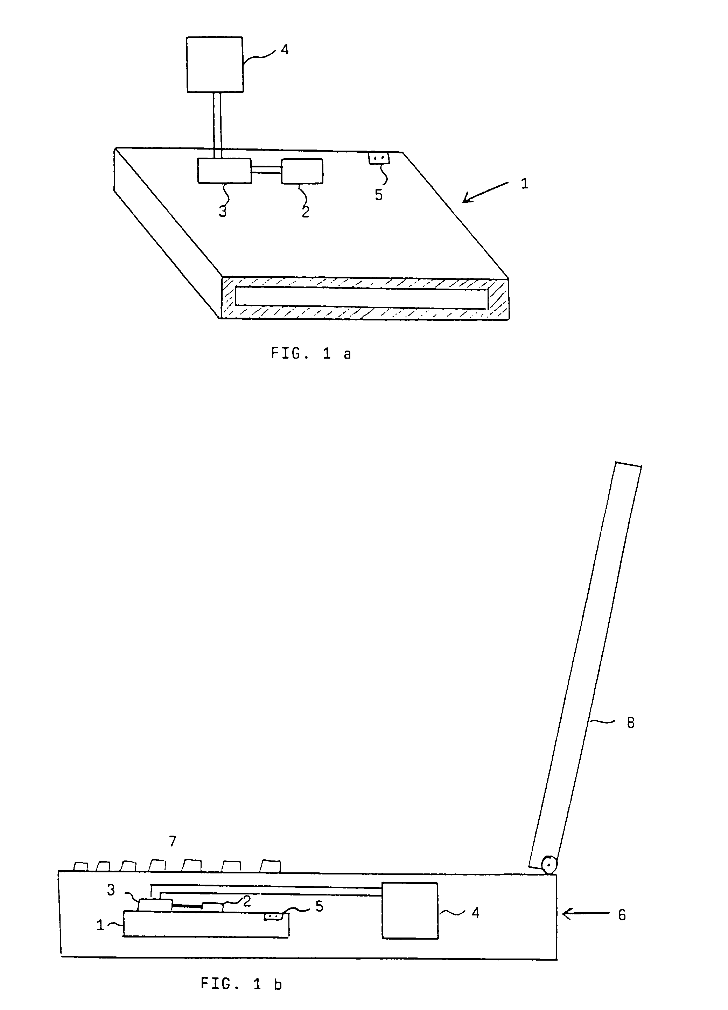

- Fig. 1 a: eine Smartdisketten-Schreib-/Leseeinrichtung 1 mit Schreib-/Lesekopf 2, Kontroller 3, der mit dem Prozessor 4 der EDV-Einrichtung verbunden ist, und ferner Steckkontakte 5 als Stromschnittstelle.
- Fig. 1 b: Querschnitt der Einrichtung nach Fig. 1 a eingebaut in einen Notebook-PC 6 mit Tastatur 7, Bildschirm 8 und Prozessor 4
- Fig. 2: Eine Smartdiskette 9 mit einem, den Schreib-/ Lesekopf zugeordneten Wandler 10, Kontroller 11, Prozessor 12, Speicher 13, Batterie 14, Stromgenerator 15, Stromregulator 16 und wahlweisem Steckkontakt als Stromschnittstelle zur Smartdisketten-Schreib-/ Leseeinrichtung 1

Die in den Figuren 1 a und 1 b dargestellte Smartdisketten-Schreib-/ Leseeinrichtung 1 enthält einen fest installierten Schreib-/Lesekopf 2 sowie den Kontroller 3, der die Verbindung zwischen dem Schreib-/Lesekopf der Smartdisketten-Schreib-/ Leseeinrichtung und dem Prozessor 4 der EDV-Einrichtung herstellt.

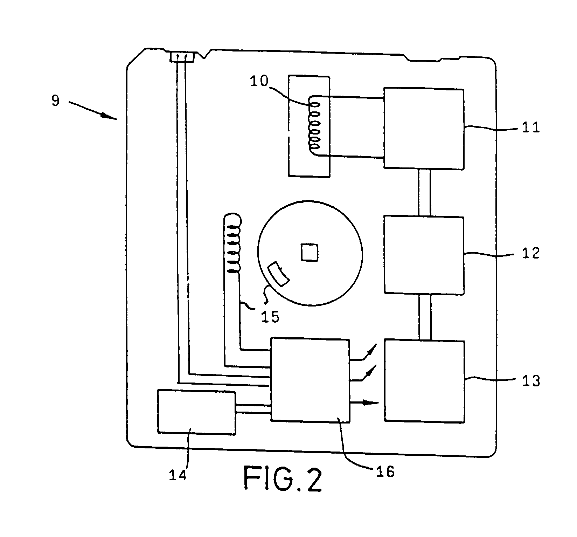

Bei der in Figur 2 dargestellten Smartdiskette handelt es sich um eine übliche Smartdiskette mit einem zusätzlichen Steckkontakt, der wahlweise für die Stromversorgung der Smartdiskette, im in die Smartdisketten-Schreib-/Leseein-richtung eingestecktem Zustand, benutzt wird.

Aus der folgenden Auflistung geht die Vielzahl der Anwendungsmöglichkeiten einer nach der Erfindung gestalteten Smartdisketten-Schreib-/Leseeinrichtung mit den damit verbundenen vorteilen hervor:
Anwendungsmöglichkeiten/vorteile:
- Schreib-/Leseeinrichtung für Smartdisketten mit einem Speicher von mehreren Megabytes
- einsetzbar in Notebooks und Notepads ohne bewegliche Teile
- einsetzbar in üblichen EDV-einrichtungen, bei denen ein 3 1/2 Zoll-Laufwerk aus Sicherheitsgründen nicht installiert sein soll (Die Schreib-/ Leseeinrichtung kann mit Smartdisketten aber nicht mit üblichen Disketten benutzt werden.)
- einfacher Datenaustausch mit Smartdisketten zwischen üblichen 3 1/2 zoll-Laufwerken und Notebooks/Notepads ohne bewegliche Teile
- Hoher Datendurchsatz (bis zu 500 kbit/sec)

## Patentansprüche

1. Datenspeicher-System, bestehend aus:
- einem in EDV-Einrichtungen einbaubaren Gerät (1) mit der äußeren Form eines 88.9 mm-(3 1/2 Zoll-) Diskettenlaufwerkes, das einen Schreib-/Lesekopf (2) und einen Kontroller (3) beinhaltet, der das Protokoll zum Schreiben und Lesen abhandelt und mit der EDV-Einrichtung verbunden ist, und
- einem in das Datenschreib-/Lesegerät einführbaren, als Smartdiskette ausgebildeten Datenträger (9) in der Form und mit den Abmessungen einer 88.9 mm-(3 1/2 zoll-) Diskette, der also elektronische Bauteile, wie Xontroller (11), Prozessor (12), und Speicher (13) sowie einen fest mit dem Datenträger (9) verbundenen magnetischen Wandler (10) aufweist, wobei das System so ausgebildet ist, daß eine Datenübertragung über eine durch den Schreib-/ Lesekopf (2) und den feststehenden magnetischen Wandler (10) gebildete Schnittstelle erfolgen kann, dadurch gekennzeichnet, daß das Datenschreib-/Lesegerät (1) keine beweglichen Teile aufweist, d.h. es ist kein Antriebsmotor für eine Magnetscheibe vorhanden, und der Schreib-/lesekopf (2) ist unbeweglich in dem Schreib-/ Lesegerät (1) befestigt, so daß der Datenaustausch zwischen dem Datenschreib-/Lesegerät (1) und dem als smartdiskette ausgebildeten Datenträger (9) nur über den feststehenden magnetischen wandler (10) mit nachgeschaltetem Prozessor (12) und Speicher (13) erfolgt.

2. System nach Anspruch 1, dadurch gekennzeichnet, daß sich in dem Gerät (1) ein Steckkontakt (5) befindet, der der Stromversorgung der elektronischen Bauteile der Diskette (9) dient.

## Claims

1. A data storage system comprising:
- a device (1) which can be incorporated in EDP devices with the external shape of a 88.9 mm (3½ inch) diskette drive, which contains a read/write head (2) and a controller (3), which transacts the protocol to write and read and is connected with the processor of the EDP device, and
- a data carrier (9) constructed as a smart-diskette in the shape and the dimensions of a 88.9 mm (3½ inch) diskette which can be inserted into the data read/write device (1), which data carrier therefore has electronic components, like controller (11), processor (12) and memory (13) as well as a magnetic transducer (10) which is firmly connected with the data carrier (9), wherein the system is constructed so, that a data transfer can be carried out through an interface formed by the read/write head (2) and the stationary magnetic transducer (10),
characterised in that the data read/write device (1) has no moving parts at all, i.e. there is no drive motor for a magnetic disc present, and the read/write head (2) is fastened stationarily in the read/write device (1), so that the data exchange between the data read/write device (1) and the data carrier (9) constructed as a smart-diskette is carried out only through the stationary magnetic transducer (10) with a downstream connected processor (12) and memory (13).

2. System according to claim 1, characterised in that in the device (1) a plug connector (5) is situated, which serves for the current supply of the electronic components of the diskette (9).

## Revendications

1. Système de mémoire de données, comprenant:
- un appareil (1) qui peut être intégré dans des systèmes informatiques, à l'allure extérieure d'une unité de disquettes (3 pouces ½) de 88,9 mm pourvue d'une tête de !ecture/écriture (2) et d'un contrôleur (3) qui traite le protocole pour l'écriture et la lecture et est relié au système informatique, et
- un support de données (9) insérable dans l'appareil de lecture/écriture de données (1), ayant la forme d'une disquette intelligente et les dimensions d'une disquette (3 pouces ½) de 88,9 mm qui présente des composants électroniques tels que contrôleur (11), processeur (12) et mémoire (13) ainsi qu'un transducteur magnétique (10) raccordé par liaison fixe au support de données (9), le système étant conçu de telle sorte qu'une transmission des données puisse avoir lieu via une interface formée par la tête de lecture/écriture (2) et le transducteur magnétique (10) fixe,
caractérisé en ce que l'appareil de lecture/écriture de données (1) ne présente aucune pièce mobile, c.-à-d. qu'il n'y a pas de moteur d'entraînement pour un disque magnétique et la tête de lecture/écriture (2) est fixée de façon à être parfaitement immobile si bien que l'échange des données entre l'appareil de lecture/écriture de données (1) et le support de données (9) conçu comme une disquette intelligente n'a lieu que par le transducteur magnétique (10) fixe avec processeur (12) branché en aval et mémoire (13).

2. Système selon revendication 1 caractérisé en ce qu'il y a un contact enfichable (5) dans l'appareil (1) qui sert à l'alimentation en courant des composants électroniques de la disquette (9).
